# EUROPÄISCHE PATENTSCHRIFT

(11) **EP 0 862 788 B1**
(45) Veröffentlichungstag und Bekanntmachung des Hinweises auf die Patenterteilung: **26.02.2003**
(21) Anmeldenummer: 96945708.4
(22) Anmeldetag: 06.11.1996
(51) Int. Cl.: H01L 21/98, H01L 25/065

(54) **HERSTELLUNGSVERFAHREN EINES VERTIKAL INTEGRIERTEN HALBLEITERBAUELEMENTS**
METHOD OF PRODUCING A VERTICALLY INTEGRATED SEMICONDUCTOR COMPONENT
PROCEDE DE PRODUCTION D'UN COMPOSANT A SEMI-CONDUCTEUR INTEGRE VERTICALEMENT

(30) Priorität: 22.11.1995 DE 19543540
(43) Veröffentlichungstag der Anmeldung: 09.09.1998
(73) Patentinhaber: Infineon Technologies AG, 81669 München (DE)
(72) Erfinder: LAUTERBACH, Christl, D-85635 Höhenkirchen-Siegertsbrunn (DE); WEBER, Werner, D-80637 München (DE)
(74) Vertreter: Schweiger, Martin, Dipl.-Ing.
(86) Internationale Anmeldenummer: DE9602108
(87) Internationale Veröffentlichungsnummer: WO97019462

(56) Entgegenhaltungen:
- EP-A- 0 206 696
- EP-A- 0 610 709
- EP-A- 0 635 885
- DE-A- 4 433 833
- DE-A- 4 433 845
- US-A- 4 675 370
- US-A- 5 354 929
- US-A- 5 416 233

## Beschreibung

Die vorliegende Erfindung betrifft ein Verfahren zur Herstellung von Halbleiterbauelementen mit einer speziellen Kontaktstrukturierung, die für eine vertikale elektrisch leitende Verbindung von mehreren Halbleiterbauelementen vorgesehen ist.

Halbleiterschaltungen werden heute in Planartechnik hergestellt. Die erreichbare Komplexität auf einem Chip ist begrenzt durch dessen Größe und die erreichbare Strukturfeinheit. Die Leistungsfähigkeit eines aus mehreren miteinander verbundenen Halbleiterchips bestehenden Systems ist bei konventioneller Technik wesentlich begrenzt durch die begrenzte Zahl der möglichen Verbindungen zwischen einzelnen Chips über Anschlußkontakte, die geringe Geschwindigkeit der Signalübermittlung über solche Verbindungen zwischen verschiedenen Chips, die bei komplexen Chips begrenzte Geschwindigkeit durch weit verzweigte Leiterbahnen und den hohen Leistungsverbrauch der Interface-Schaltungen.

Diese aufgezeigten Beschränkungen bei der Verwendung der Planartechnik lassen sich mit dreidimensionalen Techniken der Verschaltung überwinden. Die Anordnung mehrerer Bauelementebenen übereinander erlaubt eine parallele Kommunikation dieser Komponenten mit geringem Aufwand für elektrisch leitende Verbindungen in einer Ebene. Außerdem werden geschwindigkeitsbegrenzende Interchip-Verbindungen vermieden.

Ein bekanntes Verfahren zur Herstellung dreidimensionaler IC's beruht darauf, über einer Ebene von Bauelementen eine weitere Halbleiterschicht abzuscheiden und diese über ein geeignetes Verfahren (z. B. lokale Erwärmung mittels Lasers) zu rekristallisieren und darin eine weitere Bauelementebene zu realisieren. Auch diese Technik weist wesentliche Begrenzungen auf, die durch die thermische Belastung der unteren Ebene bei der Rekristallisierung und die durch Defekte begrenzte erreichbare Ausbeute gegeben sind.

In einem alternativen Verfahren werden die einzelnen Bauelementebenen getrennt voneinander hergestellt. Diese Ebenen werden auf wenige µm gedünnt und mittels Wafer-bonding miteinander verbunden. Die elektrischen Verbindungen werden in der Weise hergestellt, daß die einzelnen Bauelementebenen auf der Vorder- und Rückseite mit Kontakten zur Interchip-Verbindung versehen werden.

Aus der US 4 939 568 ist ein vertikal integriertes Halbleiterbauelement und ein dazugehöriges Herstellungsverfahren bekannt, bei dem die vertikale leitende Verbindung über vertikale Metallstifte erfolgt, die sich im Substrat jeweils einer Schichtebene befinden. Das Herstellungsverfahren sieht vor, die nicht mit einer Schichtstruktur versehene Rückseite des Substrats soweit abzuschleifen, bis diese vertikalen leitenden Verbindungen freigelegt sind. Diese Seite des Substrates kann dann ebenfalls mit Strukturen versehen werden. Für eine direkte Verbindung mit einer nachfolgenden Ebene des Bauelementes werden die freigelegten Oberflächen der vertikalen leitenden Verbindungen mit Aluminiumkontakten versehen.

Aus der DE 43 14 907 C1 ist ein Herstellverfahren für vertikal integrierte Bauelemente bekannt, bei dem die Bauelementebenen zunächst auf getrennten Substraten erzeugt werden. Nach dem Aufbringen einer Planarisierungsschicht auf dem unteren Substrat und Dünnen des oberen Substrats werden beide Substrate miteinander verbunden. Zur elektrisch leitenden Verbindung zwischen Bauelementebenen sind im Substrat integrierte, stiftförmige Metallstrukturen vorgesehen.

In der DE 44 00 985 C1 wird vorgeschlagen, für die Planarisierungsschicht Polyimid zu verwenden, zur Verbindung der Bauelementebenen zunächst Kontaktlöcher zu erzeugen und diese anschließend mit einem Kontaktmaterial aufzufüllen. Nachteilig an dieser Ausführung ist die Polyimidschicht, die beim Härten (bzw. Imidisieren) Wasser abspaltet und einen Reaktionsschwund zeigt. Abgespaltetes Wasser verbleibt zum großen Teil im Bauelement und führt zu zusätzlichen Spannungen, die das fertige Bauelement in seiner Funktion oder Haltbarkeit beeinträchtigen können. Außerdem besitzt eine Polyimidschicht eine nur geringe Planarisierungswirkung von z.B. 30%, so daß mehrere Schichten erforderlich sind, die wiederum Haftungsprobleme untereinander aufweisen.

Aus der EP-A-0635 885 ist ein vertikal integriertes Halbleiterbauelement bekannt, bei dem zwei Bauelementebenen durch eine Verbindungsschicht miteinander verbunden sind und welches vertikale Kontaktstrukturen zur Verbindung der beiden Bauelementebenen aufweist.

Aus der US-A-5,416,233 ist die Verwendung eines Benzocyclobuten (BCB) für integrierte Schaltungen und Multichipmodule.

Aus der US-A-5,354,929 ist es bekannt, daß BCB eine niedrige Dielektrizitätskonstante besitzt. Die Verwendung von BCB als Klebstoff ist aus der US-A-4,675,370 bekannt.

Problem der vorliegenden Erfindung ist es, eine verbesserte Struktur und ein einfaches Herstellverfahren für ein vertikal integriertes Bauelement anzugeben und insbesondere ein geeignetes Material für die Zwischenschicht aufzufinden, welches eine sichere und spannungsfreie Verbindung zwischen den Bauelementebenen gewährleistet und welches weitere erforderliche Fertigungsschritte für das vertikal integrierte Bauelement ohne Beschädigung übersteht.

Diese Aufgabe wird mit einem Halbleiterbauelement nach Anspruch 1 gelöst. Herstellverfahren und weitere vorteilhafte Ausgestaltungen der Erfindung ergeben sich aus den übrigen Ansprüchen.

Das erfindungsgemäße Halbleiterbauelement umfaßt zumindest zwei Bauelementebenen, die jeweils in einem eigenen Substrat realisiert sind. Im erfindungsgemäßen Halbleiterbauelement sind die in getrennten Substraten realisierten Bauelementebenen durch eine Verbindungsschicht verklebt, welche ein homopolymerisiertes Benzocyclobuten (BCB) umfaßt. Die elektrische Verbindung zwischen den Bauelementebenen bzw. den in den Substraten realisierten Bauelementen wird durch eine vertikale Kontaktstruktur realisiert, die einen ersten Kontaktbereich reich auf dem ersten Substrat mit einem zweiten Kontaktbereich auf dem zweiten Substrat elektrisch leitend verbindet.

Mit der Erfindung wird erstmals eine Struktur vorgeschlagen, die eine spannungsfreie Verbindung der beiden Substrate ermöglicht. Da das zweite (obere) Substrat vor dem Verbinden auf eine möglichst geringe Schichtdicke von wenigen um gedünnt wird, ist dieses besonders gegen thermomechanische Spannungen empfindlich. Da beim Härten der mit BCB realisierten Verbindungsschicht ein nur geringer Reaktionsschwund (von zum Beispiel weniger als 5 Prozent) auftritt, werden im erfindungsgemäßen Halbleiterbauelement praktisch keine zusätzlichen Spannungen an der Grenzfläche zwischen Verbindungsschicht und zweitem Substrat beobachtet.

Die Verbindungsschicht weist eine sehr gute Haftung auf Halbleitern, Oxiden und Metallen auf, die üblicherweise die Oberflächen von Halbleiterbauelementen bilden. Die Verbindungsschicht aus BCB härtet ohne Abspaltung von flüchtigen Produkten und zeigt keine Ausgasungen. Dies ist insbesondere bei einer relativ großflächigen Verklebung wie beim erfindungsgemäßen Halbleiterbauelement von Bedeutung, da solche Ausgasungen zu unerwünschten Gaseinschlüssen führen, die wiederum zu zusätzlichen Spannungen führen könnten.

BCB-Schichten sind hydrophob und zeigen keine Wasseraufnahme. Sie sind thermisch bis ca. 400°C stabil und überstehen daher übliche Umgebungsbedingungen während weiterer Fertigungsschritte und während des Betriebs des fertigen Halbleiterbauelements. Hinzu kommt, daß BCB-Schichten sehr gut planarisierend wirken. Bereits mit einer Planarisierungsschicht kann ein Planarisierungsgrad (DOP) von mehr als 90 Prozent erzielt werden. Als weitere vorteilhafte Eigenschaft zeigt die erfindungsgemäße Verbindungsschicht eine äußerst niedrige Dielektrizitätskonstante ε von 2,5 (bei 1 Mhz). Dadurch werden kapazitive Kopplungen zwischen den beiden Bauelementebenen bzw. zwischen den im ersten und im zweiten Substrat integrierten Schaltungen und Bauelementen reduziert. Die Glasübergangstemperatur der Verbindungsschicht aus BCB ist ausreichend hoch und liegt in einem Ausführungsbeispiel beispielsweise bei 350°C. So werden auch bei hohen Betriebstemperaturen des Halbleiterbauelements keine Phasenübergänge, die zu erhöhten thermischen Spannungen führen könnten, erwartet. Hervorzuheben ist weiterhin die hohe Durchbruchsspannung der Verbindungsschicht von bis zu 3 x 10⁶ Volt/cm, die für eine gute elektrische Isolation der einzelnen Bauelementebenen sorgt.

Benzocyclobutene zeigen eine thermische Umlagerung in Chino-Dimethane:

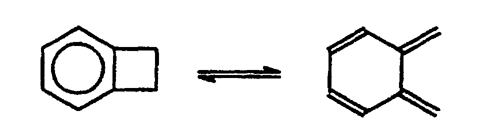

Die Chino-Dimethane wiederum gehen mit sich selbst oder mit anderen ungesättigten Verbindungen eine Cycloaddition unter Ausbildung eines Sechsrings ein: 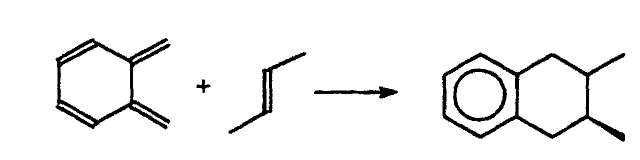 Zur Ausbildung eines vernetzten Polymers sind Bisbenzocyclobutene der allgemeinen Strukturformel 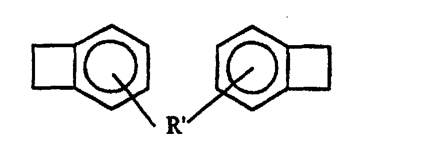 geeignet, bei denen R' ein zweiwertiger organischer oder anorganischer Rest ist, der zumindest eine ungesättigte C-C-Bindung enthält, vorzugsweise in Konjugation mit dem Aromaten. Ein bevorzugtes Bisbenzocyclobuten besitzt als Rest R eine Divinyltetramethyldisiloxangruppe, und ist unter dem Handelsnamen Cyclotene ® 3022 (Dow) im Handel erhältlich.

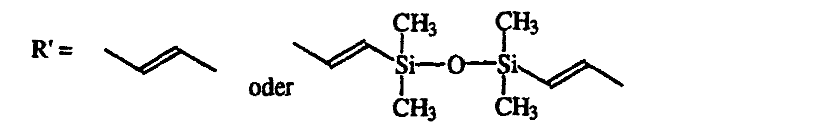

Dieses spezielle BCB wurde als Dielektrikumspolymer für elektronische Anwendungen entwickelt. Bereits beschrieben worden sind Verwendungen bei Multichipmodulen als Dielektrikums- und Zwischenschicht. Als Vorteil hat sich dabei erwiesen, daß sich auf gehärteten (polymerisierten) BCB-Schichten problemlos weitere Halbleiter-, Oxid-, Nitrid- und Metallschichten abscheiden lassen, die zum BCB eine gute Haftung aufweisen.

Die Erfindung zeigt, daß sich BCB bei vertikal integrierten Halbleiterbauelementen auch als Verbindungsschicht einsetzen läßt, wobei dem BCB eine Klebstoffunktion zukommt. Da eines der Substrate bis auf eine Dicke von nur wenigen µm gedünnt ist und sich daher wie eine Folie verhält, die empfindlich auf Verwerfungen und sonstige Spannungen mit einer Änderung ihrer Bauelementeigenschaften reagieren kann, werden an die Zwischenschicht bzw. an die Klebeverbindung hohe Anforderungen gestellt. Die BCB-Schicht erfüllt alle diese Anforderungen, ist einfach anzuwenden und führt zu einem voll funktionstüchtigen vertikal integrierten Halbleiterbauelement.

Im erfindungsgemäßen Herstellungsverfahren sind zumindest zwei Substrate integriert, die aus gleichem oder unterschiedlichem Material bestehen können. Möglich ist es auch, auf den beiden Substraten unterschiedliche Arten von Bauelementen zu erzeugen, so daß auch unterschiedliche Herstellungsprozesse zum Einsatz kommen können, die auf einem einzigen Substrat nicht kompatibel wären. Möglich ist es beispielsweise, bipolare und CMOS-Schaltungen in Siliziumsubstraten mit entsprechenden ähnlichen oder anderen Schaltungen auf beispielsweise III/V-Verbindungshalbleitersubstraten zu kombinieren. Schnelle Schaltungen in III-V-Technik können so beispielsweise mit hochintegrierten Speichern kombiniert werden. In entsprechender Weise ist es auch möglich, unterschiedliche Anwendungen in einem vertikal integrierten Halbleiterbauelement zu vereinen, beispielsweise optoelektronische und lichtverarbeitende Bauelemente auf zum Beispiel InGaAsP/InP- oder GaAs/GaAlAs-Basis mit den entsprechenden Treiber- oder Verstärkerschaltungen in Silizium.

Ein erfindungsgemäßes Verfahren zur Herstellung des neuartigen vertikal integrierten Halbleiterbauelements wird im folgenden anhand von Ausführungsbeispielen und den dazugehörigen Figuren näher erläutert.
- Figur 1: zeigt im schematischen Querschnitt ein erstes Substrat mit Ausschnitten einer darin integrierten Schaltung bzw. eines Bauelements.
- Figuren 2 bis 4: zeigen ein zweites Substrat mit darin integriertem Bauelement bzw. Schaltung im schematischen Querschnitt, während in den
- Figuren 5 und 6: in gleicher Darstellungsweise zwei Verfahrensstufen beim Verbinden der beiden Substrate dargestellt sind.
- Figur 7: zeigt ein mögliches Temperaturprogramm, mit dem erfindungsgemäß die Klebeverbindung zwischen erstem und zweitem Substrat hergestellt werden kann.

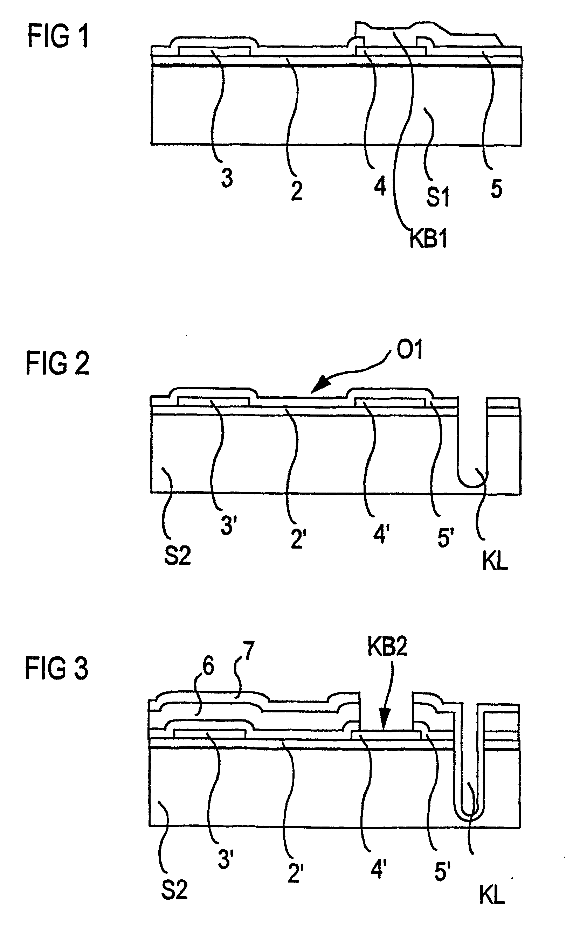

Figur 1 zeigt ein erstes Substrat S1, in dem eine Halbleiterschaltung realisiert ist. Der Übersichtlichkeit halber sind von dem Bauelement nur zwei Metallisierungen 3 und 4 dargestellt, die über einer isolierenden Schicht 2 angeordnet sind. Während die Metallisierung 3 von einer Passivierungsschicht 5 abgedeckt ist, ist die Metallisierung 4 zur Kontaktierung mit einer weiteren Bauelementebene, also mit einem zweiten Substrat S2 vorgesehen. Zum besseren Anschluß der Metallisierung 4 ist über dieser ein erster Kontaktbereich KB1 vorgesehen, der elektrisch leitend mit der Metallisierung 4 in Verbindung steht. Der erste Kontaktierungsbereich KB1 ist aus einem beliebigen elektrisch leitenden Material gefertigt und besteht in einer speziellen Ausführung der Erfindung aus einer niedrig schmelzenden Metallegierung, beispielsweise AuIn, AgSn oder SnPb.

In Figur 2 ist ein zweites, beispielsweise aus Silizium bestehendes Substrat 2 dargestellt, in dem ein elektrisches Bauelement oder eine Halbleiterschaltung realisiert ist. Auch hier ist wegen der besseren Übersichtlichkeit nur eine Metallisierungsebene dargestellt, über die Funktionsbereiche des Bauelements oder der Schaltung elektrisch angesteuert werden. Von der Metallisierungsebene sind in der Figur die Metallisierungen 3' und 4' über einer Isolationsschicht 2' dargestellt. Abgedeckt ist die aus den Metallisierungen 3' und 4' bestehende Metallisierungsebene mit einer Passivierungsschicht 5'. Mit Hilfe einer Ätzmaske 6, die beispielsweise über eine Photolacktechnik in einer Siliziumnitridschicht realisiert ist, wird der für das Kontaktloch KL vorgesehene Bereich definiert. Das Kontaktloch selbst wird über ein anisotropes Trockenätzverfahren bis zu einer Tiefe von beispielsweise 5 bis 7 µm erzeugt. Darüber wird ganzflachig eine weitere Passivierung 7 abgeschieden, beispielsweise ein Oxid, welches auch die Innenseiten des Kontaktloches bedeckt. Mittels einer Ätzmaske (nicht dargestellt), die ebenfalls mit einer Photolacktechnik geöffnet werden kann, wird die Oberfläche der Metallisierung 4 freigelegt, die den zweiten Kontaktbereich KB2 darstellt, der zur vertikalen Kontaktierung mit der ersten Bauelementebene vorgesehen ist.

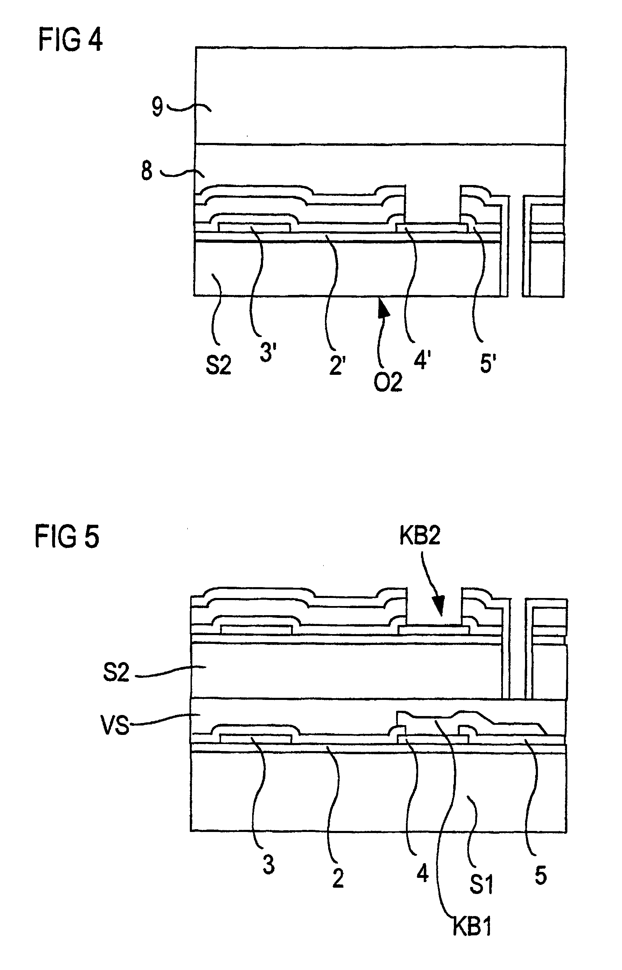

Vor der Verbindung der beiden Substrate S1 und S2 wird die Rückseite des zweiten Substrats S2 (= zweite Oberfläche O2) soweit abgetragen bzw. gedünnt, bis eine die Funktionsfähigkeit der Bauelemente bzw. der Schaltungen im Substrat S2 garantierende Restschichtdicke verbleibt. Das Abtragen der Substratrückseite kann zum Beispiel durch Rückschleifen (zum Beispiel CMP, Chemical Mechanical Polishing) oder Rückätzen erfolgen. Die Tiefe des Kontaktlochs KL ist dabei so gewählt, daß beim Dünnen des Substrats S2 der Boden des Kontaktlochs mit abgetragen wird, so daß eine durch das ganze Substrat S2 reichende Öffnung entsteht. Die Handhabung des gedünnten Substrates S2 wird erleichtert, wenn auf der Vorderseite (erste Oberfläche) des Substrats S2 vor dem Dünnen über den Bauelementstrukturen ein weiteres Substrat 9 als Hilfssubstrat zum Beispiel mittels einer Haftschicht 8 befestigt wird. Diese Haftschicht kann beispielsweise aus Polyimid, Polyacrylat oder Epoxid bestehen. Sie wird in einer Dicke von beispielsweise 1,5 µm aufgebracht und verbindet das Hilfssubstrat 9 mit dem zweiten Substrat. Besonders günstig kann dieses Kleben auf einer BCB-Schicht erfolgen, mit der vorher das Substrat S2 planarisiert wurde. Figur 4 zeigt die Anordnung nach dem teilweisen Abtragen der zweiten Oberfläche O2, wobei eine Öffnung zum Kontaktloch KL entstanden ist.

Im nächsten Schritt wird das mit dem Hilfssubstrat 9 verbundene zweite Substrat S2 mit dem ersten Substrat S1 verbunden. Dazu wird auf zumindest einer der beiden zu verbindenden Oberflächen Benzocyclobuten in einer solchen Schichtdicke aufgeschleudert, daß eine ausreichende Planarisierung erfolgt. Als BCB wird beispielsweise das bereits genannte Cyclotene 3022 verwendet, welches als Lösung in Mesitylen in verschiedenen Konzentrationen erhaltlich ist. Ein gewünschter Planarisierungsgrad bzw. eine dafür erforderliche Schichtdikke der BCB-Schicht (Verbindungsschicht VS) kann über die Konzentration der BCB-Lösung eingestellt werden. Es wird eine erste BCB-Schicht zur Planarisierung aufgeschleudert, das Lösungsmittel durch Trocknen entfernt, die erste BCB-Schicht durch Erwärmen zumindest teilweise polymerisiert und anschließend eine weitere dünne BCB-Schicht als Klebeschicht aufgeschleudert. Mit dem genannten BCB werden jedoch bereits mit einer Schicht Planarisierungsgrade von mehr als 90 Prozent erzielt. Nach dem später durchzuführenden thermischen Härtungsprozeß verbinden sich die BCB-Einzelschichten zu einer monolithischen Verbindungsschicht VS. Das gleiche gilt für eine weitere BCB-Schicht, die auf der zweiten Oberfläche O2 des zweiten Substrats aufgebracht werden kann. Nach Trocknen und gegebenenfalls Vorpolymerisieren der BCB-Schichten werden die beiden Substrat S1 und S2 paßgenau übereinandergesetzt, so daß die Öffnung des Kontaktlochs direkt über dem ersten Kontaktbereich KB1 zu liegen kommt. Zur genauen Justierung können Justiermarken auf den Substraten vorgesehen sein.

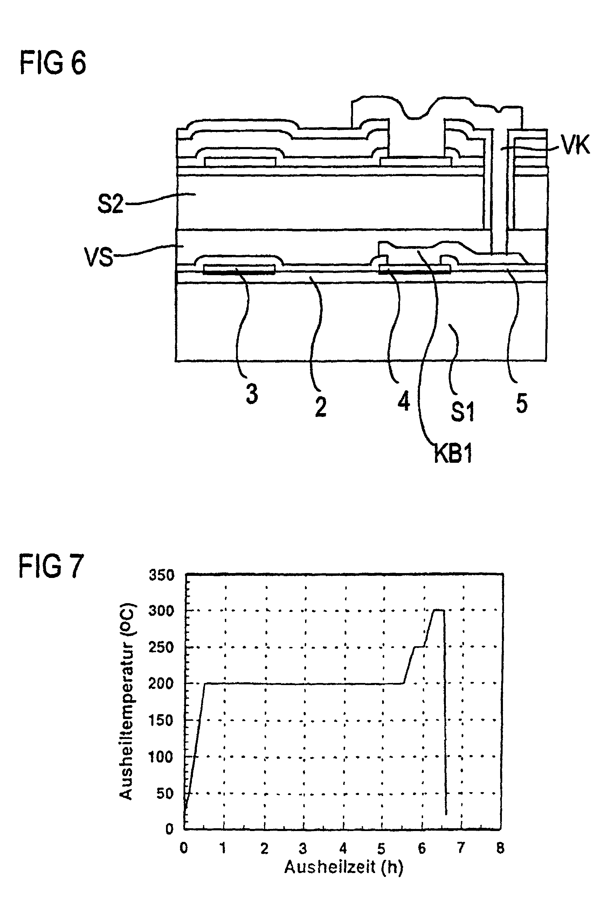

Nach dem Zusammenfügen der beiden Substrate wird die gegebenenfalls aus mehreren Teilschichten bestehende BCB-Schicht thermisch zur monolithischen Verbindungsschicht VS gehärtet. Dazu wird die Anordnung mit möglichst niedriger Aufheizrate von beispielsweise 0,5 bis 5° pro Minute bis zu einer zur Härtung ausreichenden Temperatur aufgeheizt, die üblicherweise zwischen 180 und 220°C. zum Beispiel bei 200°C, liegt. Nach einer Haltezeit von mehreren Stunden bei dieser Temperatur ist ein Polymerisationsgrad von 80 bis 98 Prozent erreicht, der bereits zu einer spannungsfreien dimensionsstabilen Verbindung zwischen beiden Substraten ausreichend ist. Zur vollständigen Härtung wird nun noch kurz auf eine höhere Temperatur von 250 bis 350°C aufgeheizt. Danach kann rasch abgekühlt werden. In Figur 7 ist dieses zur Härtung der BCB-Schicht (EM) geeignetes Temperaturprogramm dargestellt.

Nach dem Verbinden der beiden Substrate mittels der Verbindungsschicht VS wird das Hilfssubstrat samt der Klebstoffschicht 8 entfernt. Dies kann beispielsweise durch Abätzen, Plasmaveraschen oder anderweitiges Auflösen der Klebstoffschicht erfolgen. Gegebenenfalls wird die Oberfläche anschließend noch gereinigt. Figur 5 zeigt die Anordnung nach diesem Verfahren.

Im nächsten Schritt wird die Verbindungsschicht VS durch das Kontaktloch hindurch entfernt, bis im Bereich des Kontaktlochs die Oberfläche des ersten Kontaktbereichs KB1 freigelegt ist. Dazu ist ein Trockenätzverfahren mit einem CF₄/O₂haltigen Plasma geeignet.

Im nächsten Schritt wird die vertikale Kontaktstruktur VK erzeugt, indem ganzflächig auf die erste Oberfläche des zweiten Wafers S2 ein ausreichend elektrisch leitfähiges Kontaktmaterial aufgebracht wird, welches außerdem zur Auffüllung des Kontaktlochs geeignet ist, beispielsweise CVD-Wolfram oder Wolframsilizid. Auf diese Weise wird eine elektrisch leitende Verbindung zwischen dem ersten Kontaktbereich KB1 des ersten Substrats bzw. der ersten Bauelementebene und dem Kontaktbereich KB2 der zweiten Bauelementebene hergestellt. Anschließend wird überschüssiges Kontaktmaterial entfernt, beispielsweise durch Abätzen über eine beispielsweise aus Siliziumnitrid bestehende Atzmaske. Figur 6 zeigt die Anordnung nach diesem Schritt, wobei nun ein bereits voll funktionsfähiges Halbleiterbauelement mit zwei Bauelementebenen vorliegt.

Zur weiteren Steigerung der Integrationsdichte kann über dem Halbleiterbauelement noch eine weitere Bauelementebene aufgebracht und vertikal mit der darunterliegenden Bauelementebene kontaktiert werden, wobei das eben hergestellte Halbleiterbauelement anstelle des ersten Substrats S1 in dem erfindungsgemäßen Verfahren eingesetzt wird.

In einer Variation des erfindungsgemäßen Verfahrens ist es möglich, das Kontaktloch KL erst nach dem Zusammenfügen der beiden Substrate zu erzeugen. In entsprechender Abwandlung des Verfahrens schließen sich danach folgende Schritte an: Abscheiden einer Passivierungsschicht 7, Trockenätzen der Passivierungs- und der Verbindungsschicht VS im Bereich des Kontaktlochs KL, Abscheiden eines Kontaktmaterials unter Herstellung einer elektrisch leitenden Verbindung zwischen erstem und zweitem Kontaktbereich, sowie Rückätzen überschüssigen Kontaktmaterials. Auch mit dieser Variante wird eine Struktur nach Figur 6 erhalten.

## Patentansprüche

1. Verfahren zur Herstellung eines Halbleiterbauelements mit Schichtstruktur und vertikaler Kontaktstruktur (VK) mit den Schritten
- Ausbilden eines Bauelements oder einer Schaltung mit einem ersten Kontaktbereichs (KB1) in einem ersten Substrat (S1)
- Ausbilden eines weiteren Bauelements oder einer weiteren Schaltung mit einem zweitem Kontaktbereichs (KB2) in einer ersten Oberfläche eines zweiten Substrats (S2)
- Ganzflächiges Abtragen von Substratmaterial der zweiten Oberfläche des zweiten Substrats (S2) zur Reduzierung der Schichtdicke
- Verkleben des ersten Substrats (S1) mit der zweiten Oberfläche des zweiten Substrats (S2) mit Hilfe von Bisbenzocyclobuten bei dem das homopolymerisierte Benzocyclobuten abgeleitet ist von einem Monomer mit einer der allgemeinen Strukturen 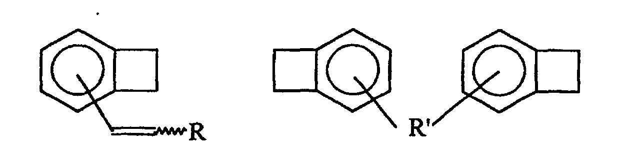
wobei R einen beliebigen aliphatischen oder aromatischen Rest darstellt, und 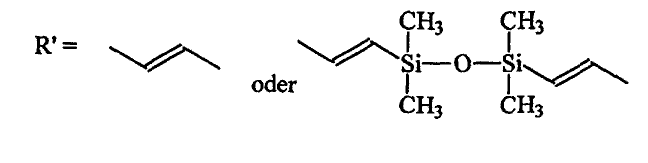 und
- Herstellen einer elektrisch leitenden Verbindung zwischen dem ersten Kontaktbereichs (KB1) und dem zweitem Kontaktbereichs (KB2) durch eine vertikale Kontaktstruktur (VK),
**dadurch gekennzeichnet, dass**
zum Verkleben von erstem und zweiten Substrat zunächst eine Planarisierungsschicht auf der ersten Oberfläche des ersten Substrats durch Aufschleudern einer BCB-Lösung, Trocknen und . teilweise Polymerisieren erzeugt wird, anschließend als Klebeschicht eine weitere dünne BCB-Schicht auf die Planarisierungsschicht oder auf die zweite Oberfläche des zweiten Substrats aufgeschleudert wird, die beiden Substrate dann übereinandergesetzt und die Verbindungsschicht thermisch gehärtet wird.

2. Verfahren nach Anspruch 1,
bei dem das Herstellen der elektrisch leitenden Verbindung folgende Schritte umfaßt:
- Ausbilden eines Kontaktloches (KL) in der ersten Oberfläche; (01) des zweiten Substrats und in der Verbindungsschicht (VS) durch Ätzen unter Freilegen des ersten Kontaktbereichs (KB1) des ersten Substrats, wobei zum Ätzen des Kontaktlochs in der Verbindungsschicht ein CF₄/O₂ haltiges Plasma verwendet wird,
- Auffüllen des Kontaktloches durch ganzflächiges Abscheiden und Rückätzen eines Kontaktmaterials so, daß die vertikale Kontaktstruktur (VK) entsteht.

3. Verfahren nach Anspruch 1,
bei dem im ersten Substrat (S1) ein Kontaktloch (KL) vor dem Verkleben der beiden Substrate erzeugt und nach dem Verkleben mit Kontaktmaterial aufgefüllt wird.

4. Verfahren nach einem der Ansprüche 1 bis 3,
bei dem zur thermischen Härtung zunächst mit einer Aufheizrate von 0,5 - 5 °/min bis zu einer Temperatur von 180 - 220°C aufgeheizt wird, bei dieser Temperatur gehalten wird, bis ein Polymerisationsgrad von 80 bis 98 % erreicht ist, zur vollständigen Polymerisation auf eine Temperatur von 250 bis 350°C aufgeheizt und anschließend rasch abgekühlt wird.

5. Verfahren nach einem der Ansprüche 1 bis 4,
bei dem die vertikale Kontaktstruktur (VK) aufgebaut wird aus Wolfram, Wolframsilizid oder Wolframnitrid.

6. Verfahren nach einem der Ansprüche 1 bis 5,
bei dem zumindest für eines der Substrate (S1, S2) Silizium verwendet wird.

7. Verfahren nach einem der Ansprüche 1 bis 6,
bei dem die vertikale Kontaktstruktur (VK) stiftförmig ausgebildet wird.

## Claims

1. Method for fabricating a semiconductor component with a layer structure and a vertical contact structure (VK), having the following steps:
- formation of a component or a circuit with a first contact region (KB1) in a first substrate (S1)
- formation of a further component or a further circuit with a second contact region (KB2) in a first surface of a second substrate (S2)
- whole-area removal of substrate material of the second surface of the second substrate (S2) in order to reduce the layer thickness
- bonding of the first substrate (S1) to the second surface of the second substrate (S2) with the aid of bisbenzocyclobutene, in the case of which the homopolymerized benzocyclobutene is derived from a monomer having one of the general structures 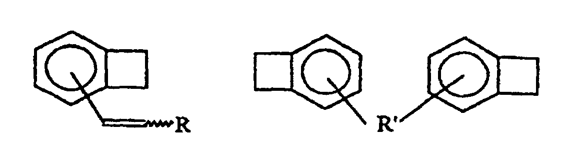
where R represents an arbitrary aliphatic or aromatic radical, and 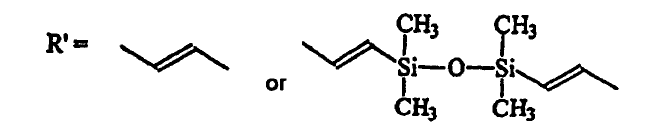 and
- production of an electrically conductive connection between the first contact region (KB1) and the second contact region (KB2) by means of a vertical contact structure (VK),
**characterized in that**
for the purpose of bonding first and second substrates, firstly a planarization layer is produced on the first surface of the first substrate by spinning on a BCB solution, drying and partial polymerization, afterwards, as adhesive layer, a further thin BCB layer is spun onto the planarization layer or onto the second surface of the second substrate, the two substrates are then placed one over the other and the connecting layer is thermally cured.

2. Method according to Claim 1,
in which the production of the electrically conductive connection comprises the following steps:
- formation of a contact hole (KL) in the first surface (01) of the second substrate and in the connecting layer (VS) by etching with the first contact region (KB1) of the first substrate being uncovered, a plasma containing CF₄/O₂ being used for etching the contact hole in the connecting layer,
- filling of the contact hole by whole-area deposition and etching-back of a contact material in such a way as to produce the vertical contact structure (VK).

3. Method according to Claim 1,
in which, in the first substrate (S1), a contact hole (KL) is produced before the bonding of the two substrates and is filled with contact material after bonding.

4. Method according to one of Claims 1 to 3,
in which, for thermal curing, the process involves firstly heating at a heating rate of 0.5 - 5°/min up to a temperature of 180 - 220°C, maintaining this temperature until a degree of polymerization of 80 to 98% is reached, and, for complete polymerization, heating to a temperature of 250 to 350°C and then rapid cooling.

5. Method according to one of Claims 1 to 4,
in which the vertical contact structure (VK) is constructed from tungsten, tungsten silicide or tungsten nitride.

6. Method according to one of Claims 1 to 5,
in which silicon is used at least for one of the substrates (S1, S2).

7. Method according to one of Claims 1 to 6,
in which the vertical contact structure (VK) is formed in pin form.

## Revendications

1. Procédé pour la préparation d'un élément semiconducteur à structure stratifiée et structure verticale de contact (VK), présentant les étapes consistant à:
- réaliser un composant ou un circuit présentant une première zone de contact (KB1) dans un premier substrat (S1),
- réaliser dans une première surface d'un deuxième substrat (S2) un autre composant ou un autre circuit présentant une deuxième zone de contact (KB2),
- enlever le matériau du substrat sur l'entièreté de la deuxième surface du deuxième substrat (S2) pour réduire l'épaisseur de la couche,
- coller le premier substrat (S1) sur la deuxième surface du deuxième substrat (S2) à l'aide de bisbenzocyclobutène, le benzocyclobutène homopolymerisé étant dérivé d'un monomère présentant l'une des structures générales: 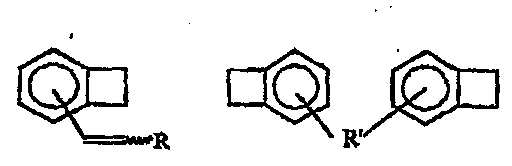
dans lesquelles R représente un groupe aliphatique ou aromatique quelconque, et 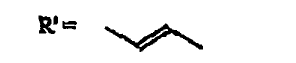 ou 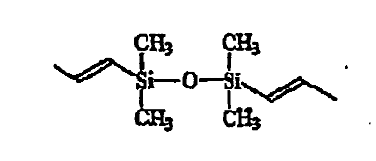 et
- préparer une liaison électriquement conductrice entre la première zone de contact (KB1) et la deuxième zone de contact (KB2) par une structure verticale de contact (VK)
**caractérisé en ce que**
- pour coller le premier et le deuxième substrat, on crée d'abord une couche de planage sur la première surface du premier substrat, par application par centrifugation, séchage et polymérisation partielle d'une solution de BCB, une autre mince couche de BCB servant de couche d'adhérence étant appliquée par centrifugation sur la couche de planage ou sur la deuxième surface du deuxième substrat, les deux substrats étant ensuite placés l'un au-dessus de l'autre et la couche de liaison étant durcie thermiquement.

2. Procédé selon la revendication 1, dans lequel la réalisation de la liaison électriquement conductrice comprend les étapes suivantes:
- formation d'un trou de contact (KL) dans la première surface (01) du deuxième substrat et dans la couche de liaison (VS) par gravure de libération de la première zone de contact (KB1) du premier substrat, un plasma contenant du CF₄/O₂ étant utilisé pour la gravure du trou de contact dans la couche de liaison, et
- remplissage du trou de contact par dépôt sur toute la surface et nouvelle gravure d'un matériau de contact pour obtenir la structure verticale de contact (VK).

3. Procédé selon la revendication 1, dans lequel, dans le premier substrat (S1), on crée un trou de contact (KL) avant le collage des deux substrats, et on le remplit de matériau de contact après le collage.

4. Procédé selon l'une des revendications 1 à 3, dans lequel, pour le durcissement thermique, on chauffe d'abord à une vitesse d'échauffement de 0,5 à 5°/min. jusqu'à une température de 180 à 220°C, on maintient à cette température jusqu'à obtenir un degré de polymérisation de 80 à 98 %, on chauffe à une température de 250 à 350°C pour obtenir une polymérisation complète et on refroidit ensuite rapidement.

5. Procédé selon l'une des revendications 1 à 4, dans lequel la structure verticale de contact (VK) est constitué de tungstène, de siliciure de tungstène ou de nitrure de tungstène.

6. Procédé selon l'une des revendications 1 à 5, dans lequel on utilise du silicium pour au moins l'un des substrats (S1, S2).

7. Procédé selon l'une des revendications 1 à 6, dans lequel la structure verticale de contact (VK) est configurée en forme de tige.
